# FASCICULE DE BREVET EUROPEEN

(11) **EP 3 531 419 B1**
(45) Date de publication et mention de la délivrance du brevet: **09.12.2026**
(21) Numéro de dépôt: 19156970.6
(22) Date de dépôt: 13.02.2019
(51) Int. Cl.: G11C 7/10, G06F 13/16

(54) **PROCÉDÉ DE GESTION DU ROUTAGE DE TRANSACTIONS ENTRE DES ÉQUIPEMENTS SOURCES, AU MOINS UN ÉQUIPEMENT CIBLE, PAR EXEMPLE UNE MÉMOIRE MULTIPORTS, ET SYSTÈME SUR PUCE CORRESPONDANT**
STEUERUNGSVERFAHREN DES ROUTINGS VON TRANSAKTIONEN ZWISCHEN QUELLENGERÄTEN UND MINDESTENS EINEM ZIELGERÄT, BEISPIELSWEISE ZWISCHEN EINEM MULTIPORT-SPEICHER, UND ENTSPRECHENDES CHIPSYSTEM
METHOD FOR MANAGING THE ROUTING TRANSACTIONS BETWEEN SOURCE DEVICES, AT LEAST ONE TARGET DEVICE, FOR EXAMPLE A MULTIPORT MEMORY, AND CORRESPONDING SYSTEM ON A CHIP

(30) Priorité: 27.02.2018 FR 1851676
(43) Date de publication de la demande: 28.08.2019
(73) Titulaire: STMicroelectronics (Rousset) SAS, 13790 Rousset (FR)
(72) Inventeur: EL KHOURASSANI, Yassine, 06600 Antibes (FR); VALDENAIRE, Patrick, 06330 Roquefort les Pins (FR); ARDICHVILI, Emmanuel, 06560 Valbonne (FR)
(74) Mandataire: Casalonga

(56) Documents cités:
- EP-A1- 1 550 953
- EP-A1- 2 294 581
- EP-A2- 1 760 723

## Description

Des modes de mise en œuvre et de réalisation de l'invention concernent le routage de transactions entre des équipements sources et au moins un équipement cible, par exemple mais non limitativement une mémoire multiports, au sein d'un système sur puce (SoC : System on Chip). Le document EP 2 294 581 A1 décrit un système de distribution de ressources de mémoire disponibles comprenant au moins deux éléments de mémoire vive (RAM) et une logique de routage de RAM. La logique de routage de RAM comprend une logique de configuration conçue pour distribuer de façon dynamique les ressources de mémoire disponibles dans une première région de mémoire dédiée à la mise en mémoire redondante et dans une seconde région de mémoire dédiée à la mise en mémoire non redondante.

Il existe un besoin de pouvoir gérer un tel routage de façon flexible en fonction de l'application envisagée.

L'invention est définie par le système sur puce de la revendication 1 et le procédé de gestion du routage de transaction de la revendication 8.

Selon un exemple il est proposé un système sur puce, comprenant
un circuit d'interconnexion (connu par l'homme du métier sous la dénomination anglo-saxonne « interconnect ») comportant plusieurs interfaces d'entrée et plusieurs interfaces de sortie,
plusieurs équipements sources respectivement couplés auxdites interfaces d'entrée,
au moins un équipement cible (par exemple une mémoire multiports) ayant plusieurs ports d'accès respectivement couplés auxdites interfaces de sortie,
chaque équipement source étant configuré pour délivrer des transactions (par exemple des transactions d'écriture ou de lecture) audit au moins un équipement cible.

Des transactions émises par des équipements sources différents peuvent être émises séquentiellement ou simultanément.

Lorsque plusieurs équipements cibles sont prévus, tous peuvent recevoir des transactions émanant de tous les équipements sources ou bien certains de ces équipements cibles peuvent recevoir des transactions de certains seulement des équipements sources.

Le système sur puce contient également des moyens de commande programmables aptes, une fois programmés, à délivrer au circuit d'interconnexion, en présence de chaque transaction émanant d'un équipement source, un mot de commande désignant un port d'accès affecté à cet équipement source,
le circuit d'interconnexion étant alors configuré pour router ladite transaction depuis l'interface d'entrée correspondante vers l'interface de sortie couplée à ce port d'accès et délivrer ladite transaction audit port d'accès, le contenu de chaque transaction délivrée à un port d'accès étant identique au contenu de la transaction correspondante délivrée par l'équipement source quel que soit le port d'accès sélectionné.

Ainsi, le circuit d'interconnexion est configuré pour recevoir avec chaque transaction un mot de commande et pour router ladite transaction vers l'un des ports d'accès en fonction de la valeur de ce mot de commande.

Ainsi, en fonction de l'application envisagée, c'est-à-dire par exemple en fonction de la nature des équipements sources, l'utilisateur pourra programmer pour chaque équipement source, la valeur du mot de commande correspondant de façon à toujours router les transactions émanant de cet équipement source vers le port d'accès choisi.

Par ailleurs, quel que soit le port d'accès choisi pour une transaction émanant d'un équipement source, le contenu de cette transaction délivré au port d'accès est identique au contenu de la transaction délivré par l'équipement source. En d'autres termes, si par exemple l'équipement cible est une mémoire double port, et si la transaction comporte une adresse d'écriture dans la mémoire, la transaction ne doit pas être perturbée par le mot de commande de façon à ce que son contenu soit identique quel que soit le port d'accès de la mémoire de façon que ladite transaction permette de pointer à la même adresse dans l'espace-mémoire de la mémoire, que la transaction soit reçue sur l'un ou l'autre des ports d'accès.

Ainsi, le même système sur puce peut être utilisé pour différentes applications nécessitant des allocations de port d'accès différentes.

Selon un exemple de mise en œuvre, une façon particulièrement simple pour obtenir que le contenu de chaque transaction délivré à un port d'accès soit identique au contenu de la transaction correspondante délivré par l'équipement source quel que soit le port d'accès sélectionné, est de prévoir que chaque transaction soit routée conjointement avec le mot de commande vers l'interface de sortie correspondante et que l'interface de sortie soit configurée pour ne pas délivrer le mot de commande au port d'accès correspondant.

Selon un mode de réalisation, chaque transaction est incorporée au sein d'un mot principal de n bits tandis que le mot de commande comporte m bits additionnels.

La valeur de m est au moins égale à 1 et dépend du nombre de ports d'accès à sélectionner.

Ainsi, si le nombre de ports d'accès est égal à 2, m pourra être égal à 1. Si le nombre de ports d'accès est égal à 3 ou 4, m sera égal à 2.

La valeur des m bits permet de programmer les moyens de commande de façon à désigner le port d'accès affecté à l'équipement source.

Chaque interface d'entrée est alors configurée pour recevoir un mot global de n+m bits comportant le mot principal et le mot de commande.

Le circuit d'interconnexion est alors avantageusement configuré pour router le mot global vers l'interface de sortie correspondante et ladite interface de sortie est avantageusement configurée pour ne pas délivrer le mot de commande au port d'accès.

Selon un exemple de réalisation, chaque interface d'entrée est couplée à l'équipement source correspondant par un bus d'entrée de n pistes et aux moyens de commande par un bus de commande de m pistes.

Le mot global de n+m bits est destiné à être routé sur un réseau de bus interne de n+m pistes au sein du circuit d'interconnexion.

Chaque interface de sortie est configurée pour recevoir un bus interne de n+m bits et est couplée au port d'accès correspondant par un bus de sortie de n pistes, les m pistes du bus interne de n+m pistes aboutissant à l'interface de sortie correspondante ne sont pas connectées au port d'accès.

Il est possible que les moyens de commande soient programmables par l'un des équipements sources, par exemple par un cœur programmable ou un (micro)processeur.

Lorsque ledit au moins un équipement cible est un moyen de mémoire multiports, ladite transaction comporte une adresse de l'espace-mémoire physique du moyen de mémoire.

Selon un autre exemple, il est proposé un procédé de gestion du routage de transaction au sein d'un système sur puce entre plusieurs équipements sources délivrant lesdites transactions et au moins un équipement cible ayant plusieurs ports d'accès.

Le procédé selon cet exemple comprend les étapes suivantes :
- équiper le système sur puce d'un circuit d'interconnexion comportant plusieurs interfaces d'entrée et plusieurs interfaces de sortie,
- coupler respectivement les interfaces d'entrée auxdits équipements sources et coupler respectivement les interfaces de sortie auxdits ports d'accès,
- configurer chaque interface d'entrée de façon à ce qu'elle puisse recevoir chaque transaction émanant de l'équipement source correspondant et un mot de commande de valeur programmable associé à cette transaction,
- configurer le circuit d'interconnexion de façon à ce que chaque transaction et son mot de commande soient routés vers l'une des interfaces de sortie en fonction de la valeur du mot de commande,
- configurer chaque interface de sortie de façon que la transaction correspondante soit délivrée au port d'accès couplé à cette interface de sortie et que le mot de commande correspondant ne soit pas délivré à ce port d'accès et, pour chaque équipement source, programmer la valeur du mot de commande correspondant de façon à affecter un port d'accès pour toutes les transactions émanant de cet équipement source.

Selon un exemple de mise en œuvre, le procédé comprend un chargement dans l'un des équipements sources, par exemple un cœur programmable ou un (micro)processeur, d'un logiciel applicatif contenant des instructions de programmation des différents mots de commande, et une programmation des différents mots de commande lors d'une exécution du logiciel applicatif.

Ledit au moins un équipement cible peut-être un moyen de mémoire multiports et ladite transaction peut comporter alors une adresse de l'espace-mémoire physique du moyen de mémoire.

D'autres avantages et caractéristiques de l'invention apparaîtront à la description détaillée de modes de mise en œuvre et de réalisation, nullement limitative, et des dessins annexés sur lesquels :

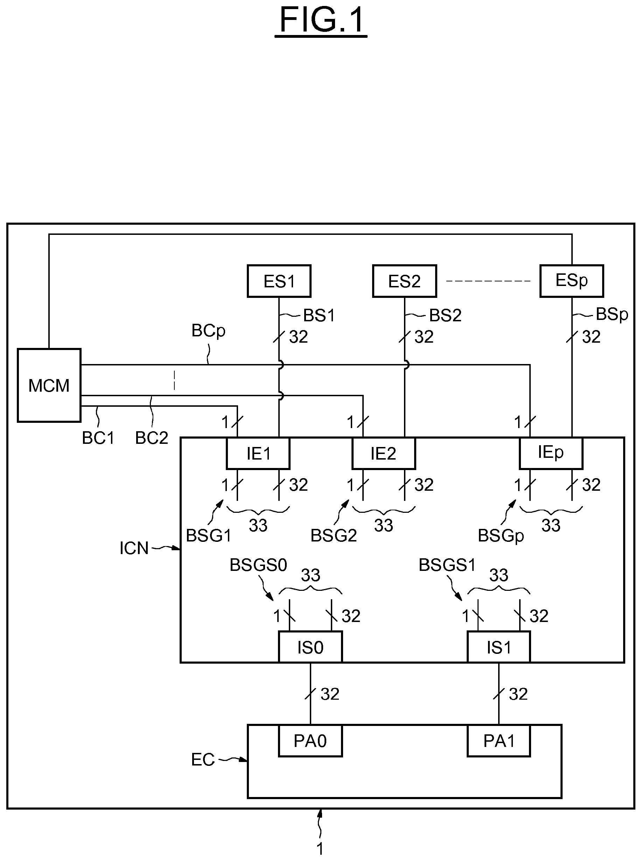

- les figures 1 à 3 illustrent schématiquement des modes de mise en œuvre et de réalisation de l'invention.

Sur la figure 1, la référence 1 désigne un système sur puce comportant plusieurs équipements sources ES1-Esp pouvant être de natures différentes.

Ainsi, l'un des équipements, par exemple l'équipement ES1 peut être un capteur LCD, un autre équipement, par exemple l'équipement ES2 peut être un processeur de traitement du signal, un autre équipement source peut être par exemple un décodeur et un autre équipement source, par exemple l'équipement ESp peut être un microprocesseur, par exemple un microprocesseur commercialisé par la société STMicroelectronics sous la référence STM32.

Le système sur puce 1 comporte également au moins un équipement cible EC, par exemple une mémoire multiports, ici une mémoire comportant deux ports d'accès PA0 et PA1.

Bien entendu, plusieurs équipements cibles, de nature identique ou différente, peuvent être prévus sur le système sur puce.

Afin d'interconnecter les équipements sources ESi avec l'équipement cible EC, le système sur puce 1 comporte également un circuit d'interconnexion ICN.

Ce circuit d'interconnexion comporte des interfaces d'entrée IE1-IEp respectivement couplées aux équipements sources ES1-ESp ainsi que des interfaces de sortie IS0, IS1 respectivement couplées aux ports d'accès PA0-PA1 de l'équipement cible EC.

Un tel circuit d'interconnexion est capable de router des transactions entre les différents équipements sources et le ou les équipements cibles.

Des transactions peuvent être par exemple des transactions d'écriture dans une mémoire, si l'équipement cible est une mémoire, ou des transactions de lecture.

La structure d'un tel circuit d'interconnexion, qui est en général un circuit d'interconnexion multicouches, ainsi que le protocole permettant l'échange et le routage des transactions à l'intérieur du circuit d'interconnexion sont bien connus de l'homme du métier.

Celui-ci pourra par exemple se référer notamment :
à l'article de Venkateswara Rao et autres intitulé « A Frame work on AMBA bus based Communication Architecture to improve the Real Time Computing Performance in MPSoC », International Journal of Computer Applications (0975-8887), Volume 91 - N° 5, Avril 2014,
   ou
à une présentation générale de ces circuits d'interconnexion effectuée en 2015 par A. Gerstlauer et disponible à l'adresse internet http://users.ece.utexas.edu/~gerstl/ee382v_f14/lectures/lecture_12.pdf.

Par ailleurs, à titre indicatif mais non limitatif, on peut utiliser par exemple le circuit d'interconnexion commercialisé par la société ARM sous la référence NIC-400 (version R0p3 ).

Comme illustré sur la figure 1, chaque interface d'entrée IEi du circuit d'interconnexion ICN est connectée à l'équipement source correspondant ESi par un bus de n bits BSi.

Dans l'exemple décrit ici, le bus est un bus de 32 bits.

Chaque transaction émanant d'un équipement source ESi est incorporée au sein d'un mot dit « mot principal » de n bits véhiculé sur le bus BSi.

Comme il est connu en la matière, une transaction, par exemple une transaction d'écriture, contient notamment un champ d'adresse et de bits de contrôle et un champ de données à écrire.

Par exemple, l'adresse contenue dans la transaction peut être codée sur 16 bits.

Le système sur puce 1 comporte par ailleurs des moyens de commande MCM, par exemple des registres, respectivement affectés aux différents équipements sources ES1-ESp et respectivement connectés aux interfaces d'entrée correspondantes IE1-IEp par des bus BC1-BCp.

Chaque interface d'entrée est donc couplée à un bus de n+m bits.

La taille du m de chaque bus BCi dépend du nombre de ports d'accès du ou des équipements cibles EC.

Dans le cas présent, puisqu'on a deux ports d'accès PA0 et PA1 pour l'équipement EC, m vaut 1.

Chaque registre contient donc 1 bit formant un mot de commande qui va être véhiculé sur le bus correspondant BCi conjointement au mot principal de 32 bits contenant la transaction.

Dans l'exemple décrit ici, les valeurs des registres sont programmées par l'un des équipements sources, en l'espèce l'équipement source ESp qui est par exemple ici le microprocesseur STM 32.

Le mot principal de 32 bits et le mot de commande de 1 bit forment un mot global de 33 bits.

D'une façon générale les différents mots globaux de 33 bits BSGi sont véhiculés vers les différentes interfaces de sortie IS0, IS1 par un réseau de bus internes de n+ m pistes

Dans l'exemple décrit ici (n=32 et m=1), les différents mots globaux de 33 bits BSGi sont véhiculés vers les différentes interfaces de sortie IS0, IS1 par un réseau de bus internes de 33pistes.

Chaque interface de sortie est donc configurée pour recevoir un bus interne de n+m bits (33 bits dans cet exemple), en l'espèce BSGS0 pour l'interface IS0 et BSGS1 pour l'interface IS1.

Par contre, comme illustré sur la figure 1, seules les n pistes (n=32 dans cet exemple) des bus BSGS0 et BSGS1 destinées à contenir la transaction, sont connectées aux ports d'accès PA0, PA1.

En d'autres termes, les m pistes (ici la 33^{ème} piste) véhiculant le mot de commande de m bits (ici le mot de commande de 1 bit), ne sont pas connectées au port d'accès correspondant.

De ce fait, la transaction délivrée à un port d'accès est identique à la transaction émanant d'un équipement source, et ce quel que soit le port d'accès sélectionné.

En fonction de la valeur du mot de commande contenu dans un registre des moyens de commande MCM, la transaction émanant de l'équipement source correspondant sera routée soit vers l'interface de sortie IS0, et donc vers le port d'accès PA0, soit vers l'interface de sortie IS1 et donc le port d'accès PA1.

Ainsi, à titre d'exemple non limitatif dans le cas ou m=1, si la valeur du bit contenu dans un registre est égale à 0, la transaction sera routée vers le port d'accès PA0 tandis que si la valeur du bit est égale à 1, la transaction sera routée vers le port d'accès PA1.

En fait, en pratique, le bit de commande est par exemple le bit de poids fort du mot d'adresse contenu dans la transaction.

Ainsi, si le mot d'adresse contenu dans la transaction est un mot de 16 bits, le mot d'adresse véhiculé sur le réseau de bus internes du circuit d'interconnexion est un mot de 17 bits. Le circuit d'interconnexion interprète donc le mot de 17 bits comme une adresse sur 17 bits. Et, le circuit d'interconnexion est alors configuré pour router ce mot de 17 bits soit vers l'interface de sortie IS0 soit vers l'interface de sortie IS1 en fonction de la valeur du bit de poids fort.

La configuration d'un circuit d'interconnexion s'effectue de façon classique, par exemple en langage VHDL. Puis, ce langage VHDL est transformé en un circuit matériel comportant un circuit de contrôle, des commutateurs et des bus et dont les différents chemins sont définis par la configuration du circuit d'interconnexion.

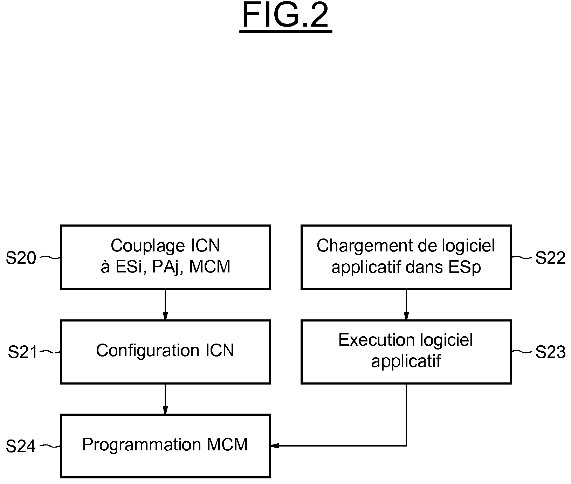

Un exemple de gestion du routage des transactions est illustré sur la figure 2.

Dans une première étape S20, on couple le circuit d'interconnexion ICN aux différents équipements sources ESi, aux différents ports d'accès PAj, ainsi qu'aux moyens de commande MCM.

Puis, on effectue dans une étape S21, la configuration du circuit d'interconnexion ICN de façon à ce que le routage d'une transaction vers un port d'accès dépende de la valeur logique du bit de commande associé à cette transaction.

Bien entendu, on a représenté sur la figure 2 l'étape S21 postérieurement à l'étape S20, il serait bien entendu tout à fait envisageable de configurer tout d'abord le circuit d'interconnexion ICN de façon à le réaliser matériellement puis d'effectuer le couplage de ce circuit d'interconnexion ICN avec les équipements sources ESi, les ports d'accès PAj, et les moyens de commande MCM.

Dans une étape S22, on charge dans l'équipement source ESP, qui est en l'espèce un microprocesseur, un logiciel applicatif qui contient des instructions de programmation des valeurs des registres MCM.

Ainsi, lors de l'exécution du logiciel applicatif (étape S23), la programmation des moyens MCM est effectuée (étape S24).

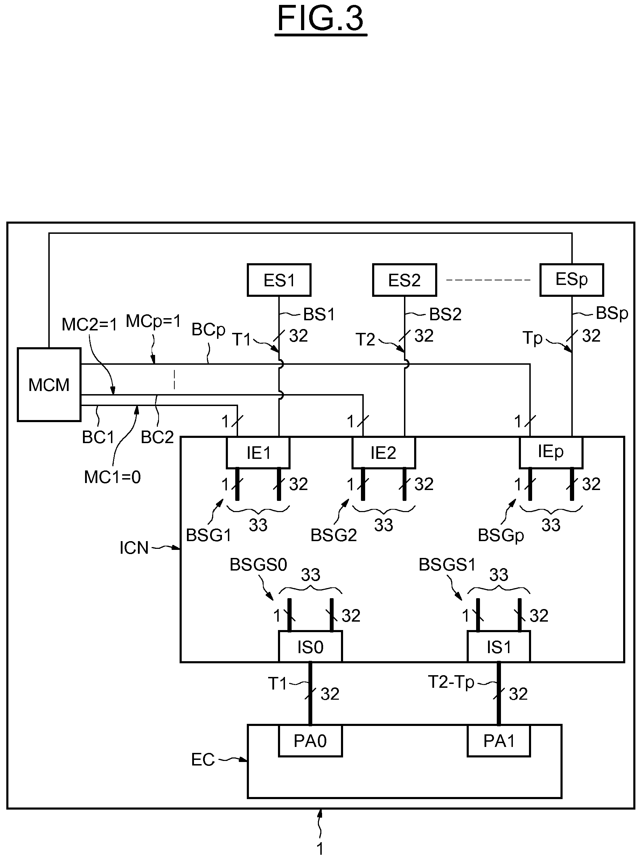

Ainsi, par exemple, comme illustré sur la figure 3, on suppose que la programmation a conduit à obtenir un mot de commande MC1 égal à 0 pour l'équipement source ES1 et des mots de commande MC2, MCp égaux à 1 pour les autres équipements sources ES2-ESp.

De ce fait, toute transaction T1 émanant de l'équipement source ES1 sera routée vers l'interface de sortie IS0 et par conséquent vers le port d'accès PA0.

Par contre, toutes transactions émanant des autres équipements sources ES2-ESp, par exemple les transactions T2-Tp seront routées vers l'interface de sortie IS1 et donc vers le port d'accès PA1.

## Revendications

1. Système sur puce, comprenant un circuit d'interconnexion (ICN) comportant plusieurs interfaces d'entrée (IEi) et plusieurs interfaces de sortie (ISj), plusieurs équipements sources (ESi) respectivement couplés auxdites interfaces d'entrée, au moins un moyen de mémoire multiports (EC) ayant plusieurs ports d'accès (PA0, PA1) respectivement couplés auxdites interfaces de sortie, chaque équipement source étant configuré pour délivrer des transactions (T1-Tp) audit au moins un moyen de mémoire multiports (EC), chaque transaction comportant une adresse de l'espace mémoire physique du moyen de mémoire pointant à la même adresse dans l'espace-mémoire de la mémoire, que la transaction soit reçue sur l'un ou l'autre des ports d'accès, et des moyens de commande programmables (MCM) aptes, une fois programmés, à délivrer au circuit d'interconnexion, en présence de chaque transaction émanant d'un équipement source, un mot de commande (MCi) désignant un port d'accès affecté à cet équipement source, le circuit d'interconnexion (ICN) étant alors configuré pour router ladite transaction depuis l'interface d'entrée correspondante vers l'interface de sortie couplée à ce port d'accès et délivrer ladite transaction audit port d'accès, le contenu de chaque transaction délivrée à un port d'accès étant identique au contenu de la transaction correspondante délivrée par l'équipement source quel que soit le port d'accès sélectionné.

2. Système selon la revendication 1, dans lequel chaque transaction est routée conjointement avec le mot de commande (MCi) vers l'interface de sortie correspondante, et l'interface de sortie est configurée pour ne pas délivrer le mot de commande au port d'accès correspondant.

3. Système selon la revendication 2, dans lequel chaque transaction est incorporée au sein d'un mot principal de n bits, le mot de commande comporte m bits additionnels, la valeur de m étant au moins égale à un et dépendant du nombre de ports d'accès à sélectionner, et la valeur des m bits permettant de programmer les moyens de commande (MCM) de façon à désigner ledit port d'accès affecté à l'équipement source, et chaque interface d'entrée est configurée pour recevoir un mot global de n+m bits comportant le mot principal et le mot de commande, le circuit d'interconnexion est configuré pour router le mot global vers l'interface de sortie correspondante, et ladite interface de sortie est configurée pour ne pas délivrer le mot de commande au port d'accès.

4. Système selon la revendication 3, dans lequel chaque interface d'entrée est couplée à l'équipement source correspondant par un bus d'entrée de n pistes et aux moyens de commande par un bus de commande de m pistes, le mot global de n+m bits est destiné à être routé sur un réseau de bus internes de n+m pistes au sein du circuit d'interconnexion, chaque interface de sortie est configurée pour recevoir un bus interne de n+m bits et est couplée au port d'accès correspondant par un bus de sortie de n pistes, les m pistes du bus interne (BSGS0, BSGS1) de n+m pistes aboutissant à l'interface de sortie correspondante n'étant pas connectées audit port d'accès.

5. Système selon l'une des revendications précédentes, dans lequel les moyens de commande (MCM) sont programmables par l'un des équipements sources (ESp).

6. Système selon la revendication 5, dans lequel l'équipement source (ESp) apte à programmer les moyens de commande comporte un cœur programmable ou un microprocesseur.

7. Système selon la revendication 5 ou 6, dans lequel l'équipement source (ESp) apte à programmer les moyens de commande incorpore un logiciel applicatif contenant des instructions destinées à programmer les moyens de commande.

8. Procédé de gestion du routage de transactions au sein d'un système sur puce entre plusieurs équipements sources délivrant lesdites transactions et au moins un moyen de mémoire multiports ayant plusieurs ports d'accès, chaque transaction comportant une adresse de l'espace mémoire physique du moyen de mémoire pointant à la même adresse dans l'espace-mémoire de la mémoire, que la transaction soit reçue sur l'un ou l'autre des ports d'accès, le procédé comprenant :
équiper le système sur puce d'un circuit d'interconnexion (ICN) comportant plusieurs interfaces d'entrée et plusieurs interfaces de sortie,
coupler respectivement les interfaces d'entrée auxdits équipement source et coupler respectivement les interfaces de sortie auxdits ports d'accès,
configurer chaque interface d'entrée de façon à ce qu'elle puisse recevoir chaque transaction émanant de l'équipement source correspondant et un mot de commande de valeur programmable associé à cette transaction,
configurer le circuit d'interconnexion (ICN) de façon à ce que chaque transaction et son mot de commande soient routés vers l'une des interfaces de sortie en fonction de la valeur du mot de commande,
configurer chaque interface de sortie de façon que la transaction correspondante soit délivrée au port d'accès couplé à cette interface de sortie et que le mot de commande correspondant ne soit pas délivré à ce port d'accès, et
pour chaque équipement source, programmer la valeur du mot de commande correspondant de façon à affecter un port d'accès pour toutes les transactions émanant de cet équipement source.

9. Procédé selon la revendication 8, comprenant un chargement dans l'un des équipements sources (ESp) d'un logiciel applicatif contenant des instructions de programmation des différents mots de commande, et une programmation des différents mots de commande lors d'une exécution du logiciel applicatif.

## Patentansprüche

1. System-on-Chip, umfassend eine Verbindungsschaltung (ICN) mit mehreren Eingangsschnittstellen (IEi) und mehreren Ausgangsschnittstellen (ISj), mehreren Quellgeräten (ESi), die jeweils an die Eingangsschnittstellen gekoppelt sind, mindestens einem Multiport-Speichermittel (EC) mit mehreren Zugangsports (PA0, PA1), die jeweils an die Ausgangsschnittstellen gekoppelt sind, wobei jedes Quellgerät so konfiguriert ist, dass es Transaktionen (T1-Tp) an das mindestens eine Multiport-Speichermittel (EC) liefert, wobei jede Transaktion eine Adresse des physischen Speicherplatzes des Speichermittels aufweist, die auf die gleiche Adresse in dem Speicherplatz des Speichers zeigt, unabhängig davon, ob die Transaktion an einem der Zugangsports empfangen wird, sowie programmierbare Steuermittel (MCM), die, nachdem sie programmiert wurden, in der Lage sind, der Verbindungsschaltung bei Vorhandensein jeder Transaktion, die von einem Quellgerät stammt, ein Steuerwort (MCi) zu liefern, das einen diesem Quellgerät zugewiesenen Zugangsport bezeichnet, wobei die Verbindungsschaltung (ICN) dann so konfiguriert ist, dass sie die Transaktion von der entsprechenden Eingangsschnittstelle zu der Ausgangsschnittstelle weiterleitet, die mit diesem Zugangsport gekoppelt ist, und die Transaktion an diesen Zugangsport liefert, wobei der Inhalt jeder an einen Zugangsport gelieferten Transaktion identisch mit dem Inhalt der entsprechenden Transaktion ist, die von dem Quellgerät unabhängig von dem ausgewählten Zugangsport geliefert wird.

2. System nach Anspruch 1, wobei jede Transaktion zusammen mit dem Steuerwort (MCi) zu der entsprechenden Ausgangsschnittstelle weitergeleitet wird und die Ausgangsschnittstelle so konfiguriert ist, dass sie das Steuerwort nicht an den entsprechenden Zugangsport liefert.

3. System nach Anspruch 2, wobei jede Transaktion in ein Hauptwort mit n Bits eingebunden ist, wobei das Steuerwort m zusätzliche Bits aufweist, wobei der Wert von m mindestens gleich eins ist und von der Anzahl der auszuwählenden Zugangsports abhängt, und wobei der Wert der m Bits es ermöglicht, die Steuermittel (MCM) so zu programmieren, dass der dem Quellgerät zugewiesene Zugangsport bezeichnet wird, und jede Eingangsschnittstelle so konfiguriert ist, dass sie ein globales Wort mit n+m Bits empfängt, das das Hauptwort und das Steuerwort aufweist, wobei die Verbindungsschaltung so konfiguriert ist, dass sie das globale Wort an die entsprechende Ausgangsschnittstelle weiterleitet, und die Ausgangsschnittstelle so konfiguriert ist, dass sie das Steuerwort nicht an den Zugangsport liefert.

4. System nach Anspruch 3, wobei jede Eingangsschnittstelle mit dem entsprechenden Quellgerät über einen Eingangsbus mit n Leiterbahnen und mit den Steuermitteln über einen Steuerbus mit m Leiterbahnen gekoppelt ist, wobei das globale Wort mit n+m Bits dazu bestimmt ist, über ein internes Busnetzwerk mit n+m Leiterbahnen innerhalb der Verbindungsschaltung weitergeleitet zu werden, wobei jede Ausgangsschnittstelle so konfiguriert ist, dass sie einen internen Bus mit n+m Bits empfängt, und mit dem entsprechenden Zugangsport über einen Ausgangsbus mit n Leiterbahnen gekoppelt ist, wobei die m Leiterbahnen des internen Busses (BSGS0, BSGS1) mit n+m Leiterbahnen zu der entsprechenden Ausgangsschnittstelle führen und nicht mit dem Zugangsport verbunden sind.

5. System nach einem der vorhergehenden Ansprüche, wobei die Steuermittel (MCM) von einem der Quellgeräte (ESp) programmierbar sind.

6. System nach Anspruch 5, wobei das Quellgerät (ESp), das in der Lage ist, die Steuermittel zu programmieren, einen programmierbaren Kern oder einen Mikroprozessor aufweist.

7. System nach Anspruch 5 oder 6, wobei das Quellgerät (ESp), das in der Lage ist, die Steuermittel zu programmieren, eine Anwendungssoftware beinhaltet, die Anweisungen enthält, die dazu bestimmt sind, Steuermittel zu programmieren.

8. Verfahren zur Verwaltung der Weiterleitung von Transaktionen innerhalb eines System-on-Chip zwischen mehreren Quellgeräten, die die Transaktionen liefern, und mindestens einem Multiport-Speichermittel mit mehreren Zugangsports, wobei jede Transaktion eine Adresse des physischen Speicherplatzes des Speichermittels umfasst, die auf die gleiche Adresse in dem Speicherplatz des Speichers zeigt, unabhängig davon, ob die Transaktion an einem der Zugangsports empfangen wird, wobei das Verfahren umfasst:
Ausstatten des System-on-Chip mit einer Verbindungsschaltung (ICN), die mehrere Eingangsschnittstellen und mehrere Ausgangsschnittstellen aufweist,
Koppeln der Eingangsschnittstellen jeweils mit dem Quellgerät und Koppeln der Ausgangsschnittstellen jeweils mit den Zugangsports,
Konfigurieren jeder Eingangsschnittstelle, derart, dass sie jede Transaktion, die von dem entsprechenden Quellgerät stammt, und ein mit dieser Transaktion verbundenes Steuerwort mit programmierbarem Wert empfangen kann,
Konfigurieren der Verbindungsschaltung (ICN), derart, dass jede Transaktion und ihr Steuerwort in Abhängigkeit von dem Wert des Steuerworts zu einer der Ausgangsschnittstellen weitergeleitet werden,
Konfigurieren jeder Ausgangsschnittstelle, derart, dass die entsprechende Transaktion an den mit dieser Ausgangsschnittstelle gekoppelten Zugangsport geliefert wird und das entsprechende Steuerwort nicht an diesen Zugangsport geliefert wird, und
Programmieren, für jedes Quellgerät, des Werts des entsprechenden Steuerworts, um allen Transaktionen, die von diesem Quellgerät stammt, einen Zugangsport zuzuweisen.

9. Verfahren nach Anspruch 8, umfassend das Laden einer Anwendungssoftware, die Anweisungen zur Programmierung der verschiedenen Steuerwörter enthält, in eines der Quellgeräte (ESp) und das Programmieren der verschiedenen Steuerwörter bei einer Ausführung der Anwendungssoftware.

## Claims

1. A system-on-chip, comprising an interconnection circuit (ICN) including several input interfaces (IEi) and several output interfaces (ISj), several pieces of source equipment (ESi) respectively coupled to said input interfaces, at least one multiport memory means (EC) having several access ports (PA0, PA1) respectively coupled to said output interfaces, each source equipment being configured to deliver transactions (T1-Tp) to said at least one multiport memory means (EC), each transaction including an address of the physical memory space of the memory means pointing to the same address in the memory space of the memory, whether the transaction is received on one or the other of the access ports, and programmable control means (MCM) capable, once programmed, of delivering to the interconnection circuit, in the presence of each transaction coming from one piece of source equipment, a control word (MCi) designating an access port assigned to this piece of source equipment, the interconnection circuit (ICN) being then configured to route said transaction from the corresponding input interface to the output interface coupled to this access port and deliver said transaction to said access port, the content of each transaction delivered to an access port being identical to the content of the corresponding transaction delivered by the piece of source equipment regardless of the selected access port.

2. The system according to claim 1, wherein each transaction is routed together with the control word (MCi) to the corresponding output interface, and the output interface is configured not to deliver the control word to the corresponding access port.

3. The system according to claim 2, wherein each transaction is incorporated within a main word with n bits, the control word includes m additional bits, the value of m being at least equal to one and dependent on the number of access ports to be selected, and the value of the m bits allowing programming the control means (MCM) so as to designate said access port assigned to the piece of source equipment, and each input interface is configured to receive a global word with n+m bits including the main word and the control word, the interconnection circuit is configured to route the global word to the corresponding output interface, and said output interface is configured not to deliver the control word to the access port.

4. The system according to claim 3, wherein each input interface is coupled to the corresponding piece of source equipment by an n-track input bus and to the control means by an m-track control bus, the global word with n+m bits is intended to be routed on an internal bus network with n+m tracks within the interconnection circuit, each output interface is configured to receive an internal bus with n+m bits and is coupled to the corresponding access port by a n-track output bus, the m tracks of the internal bus (BSGS0, BSGS1) with n+m tracks leading to the corresponding output interface being not connected to said access port.

5. The system according to one of the preceding claims, wherein the control means (MCM) are programmable by one of the pieces of source equipment (ESp).

6. The system according to claim 5, wherein the piece of source equipment (ESp) capable of programming the control means includes a programmable core or a microprocessor.

7. The system according to claim 5 or 6, wherein the piece of source equipment (ESp) capable of programming the control means incorporates application software containing instructions intended to program the control means.

8. A method for managing the routing of transactions within a system-on-chip between several pieces of source equipment delivering said transactions and at least one multiport memory means having several access ports, each transaction including an address of the physical memory space of the memory means pointing to the same address in the memory space of the memory, whether the transaction is received at one or the other of the access ports, the method comprising:
equipping the system-on-chip with an interconnection circuit (ICN) including several input interfaces and several output interfaces,
respectively coupling the input interfaces to said pieces of source equipment and respectively coupling the output interfaces to said access ports,
configuring each input interface so that it can receive each transaction from the corresponding piece of source equipment and a programmable-value control word associated with this transaction,
configuring the interconnection circuit (ICN) so that each transaction and its control word are routed to one of the output interfaces according to the value of the control word,
configuring each output interface so that the corresponding transaction is delivered to the access port coupled to that output interface and the corresponding control word is not delivered to that access port, and
for each piece of source equipment, programming the value of the corresponding control word to assign an access port for all transactions coming from this piece of source equipment.

9. The method according to claim 8, comprising loading into one of the pieces of source equipment (ESp) an application software containing instructions for programming the different control words, and programming the different control words upon execution of the application software.
